# EUROPÄISCHE PATENTANMELDUNG

(11) **EP 0 865 110 A2**
(43) Veröffentlichungstag der Anmeldung: **16.09.1998**
(21) Anmeldenummer: 98101011.9
(22) Anmeldetag: 21.01.1998
(51) Int. Cl.: H01R 13/62

(54) **Anschlussvorrichtung**

(30) Priorität: 03.02.1997 DE 19703981
(71) Anmelder: SIEMENS AKTIENGESELLSCHAFT, 80333 München (DE)
(72) Erfinder: Meiler, Werner, 92286 Rieden (DE)

(57) **Zusammenfassung**

Es wird eine aus einem Steckergehäuse (SG) und einem darin plazierbaren Steckerelement (ST) gebildete Anschlußvorrichtung angegeben, deren Komponenten lösbar miteinander verrastbar sind, wobei die seitenrichtige Positionierung der Komponenten durch Rast- und Formschlußelemente sichergestellt ist, und wobei die Kombination der Komponenten die Schutzart IP 65 erfüllt.

## Beschreibung

Die vorliegende Erfindung betrifft die konstruktive Ausgestaltung einer aus einem Steckergehäuse und einem darin plazierbaren Steckerelement gebildeten Anschlußvorrichtung.

Anschlußvorrichtungen, die aus einem Steckergehäuse und einem Steckerelement gebildet sind, sind weit verbreitet. Bekannte Steckergehäuse mit Steckerelementen waren aber insofern noch nicht ganz optimal, als aufgrund der zunehmend geringeren Dimensionierung der elektrischen Geräte entsprechend auch die Dimension der Steckergehäuse und der darin plazierbaren Steckerelemente reduziert wird, was häufig zu einem erschwerten Anschluß der mittels der Steckergehäuse und Steckerelement an das elektrische Gerät herangeführten elektrischen Leitungen geführt hat.

Die Aufgabe der vorliegenden Erfindung besteht daher darin, eine Anschlußvorrichtung anzugeben, das trotz geringer Dimensionierung einen einfachen Anschluß von elektrischen Leitungen an elektrisches Gerät ermöglicht.

Die Aufgabe wird durch die Merkmale des Hauptanspruchs gelöst.

Wenn bei der aus dem Steckergehäuse und dem mindestens einen Steckerelement gebildeten Anschlußvorrichtung Steckerelement und Steckergehäuse lösbar verrastbar sind, wobei einerseits am Steckerelement bzw. am Steckergehäuse ein Rastelement vorgesehen ist und wobei andererseits am Steckergehäuse bzw. am Steckerelement eine Ausnehmung, in die das Rastelement eingreift, vorgesehen ist, sind Steckergehäuse und Steckerelement auf einfache Weise lösbar miteinander verrastbar, so daß die an das elektrische Gerät heranzuführenden elektrischen Leitungen in das Steckergehäuse einführbar sind und mit den am Steckerelement vorgesehenen Anschlußvorrichtungen elektrisch leitend verbindbar sind, bevor das Steckerelement mit dem Steckergehäuse verrastet wird. Auf diese Weise wird eventuellen Behinderungen, die bei bekannten Anschlußvorrichtungen durch die Dimensionierung der Steckergehäuse beim Betätigen der Anschlußvorrichtungen auftreten, entgegengewirkt.

Wenn das Rastelement ein mit dem Steckerelement einstückig verbundenes Federelement ist, ist ein wiederholtes lösbares Verrasten von Steckerelement mit Steckergehäuse ohne Beschädigung der zu verrastenden Komponenten möglich.

Wenn im Steckergehäuse eine Ausnehmung vorgesehen ist, in der beim Verrasten von Steckergehäuse und Steckerelement die am Steckerelement vorgesehenen Führungskonturen geführt werden, wird das Einführen des Steckerelementes in das Steckergehäuse erleichtert.

Wenn am Steckerelement zwei Führungskonturen vorgesehen sind und im Steckergehäuse zwei Ausnehmungen vorgesehen sind und Ausnehmung und korrespondierende Führungskontur derart ausgebildet sind, daß in jede Ausnehmung nur die jeweils korrespondierende Führungskontur einführbar ist, kann das Steckerelement in das Steckergehäuse nur positionsrichtig eingeführt werden.

Das Steckergehäuse ist mit einem Gegenstück, z.B. einer Steckerplatte oder einer Kopfbaugruppe eines elektrischen Gerätes lösbar verbindbar, wobei im Falle der Steckerplatte diese Steckerplatte selbst mit der Kopfbaugruppe verbindbar ist. Wenn darüberhinaus das Gegenstück Ausnehmungen aufweist und am Gegenstück im Bereich der Ausnehmungen mindestens ein Rastelement vorgesehen ist, das in eine entsprechende Ausnehmung des Steckergehäuses eingreift, ist das Steckergehäuse mit dem Gegenstück lösbar verrastbar.

Wenn die Ausnehmung, in die das Rastelement des Gegenstücks eingreift, in einem mit dem Steckergehäuse einstückig verbundenen Federelement vorgesehen ist, ist ein wiederholtes lösbares Verrasten der Komponenten miteinander möglich.

Wenn am Steckerelement eine Führungskontur vorgesehen ist, die in eine in der Ausnehmung des Gegenstücks vorgesehene Ausnehmung einführbar ist, ist das Steckergehäuse mit verrastetem Steckerelement nur positionsrichtig mit dem Gegenstück, der Steckerplatte oder der Kopfbaugruppe, lösbar verrastbar.

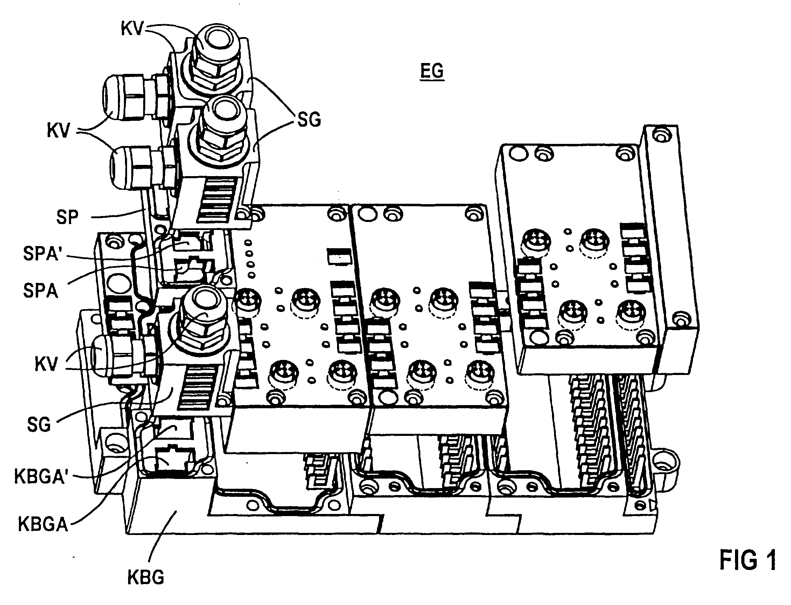

Vorteile und erfinderische Einzelheiten ergeben sich aus der nachfolgenden Beschreibung eines Ausführungsbeispiels, anhand der Zeichnungen und in Verbindung mit den Unteransprüchen. Im einzelnen zeigen
- FIG 1: ein elektrisches Gerät mit einem Steckergehäuse
- FIG 2,:
- FIG 3,:

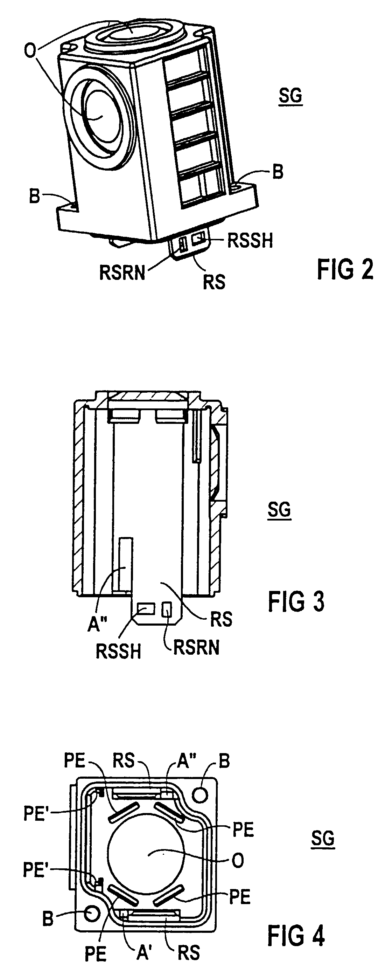

- FIG 4: ein Steckergehäuse
- FIG 5,:
- FIG 6,:

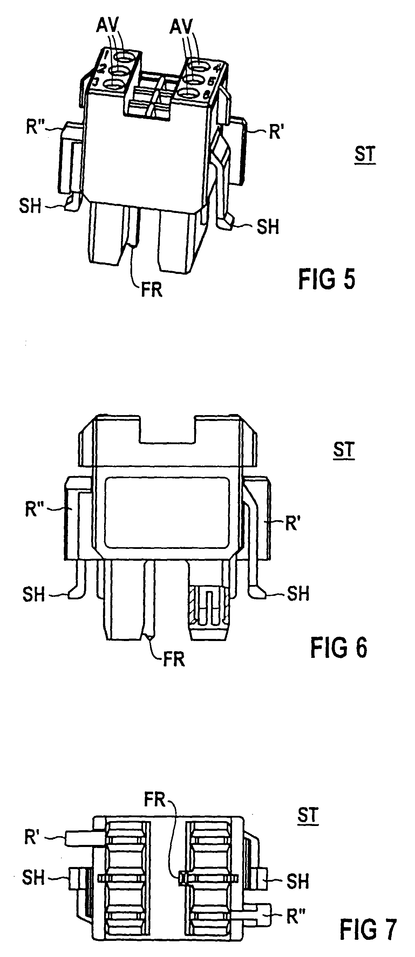

- FIG 7: ein Steckerelement und
- FIG 8,:

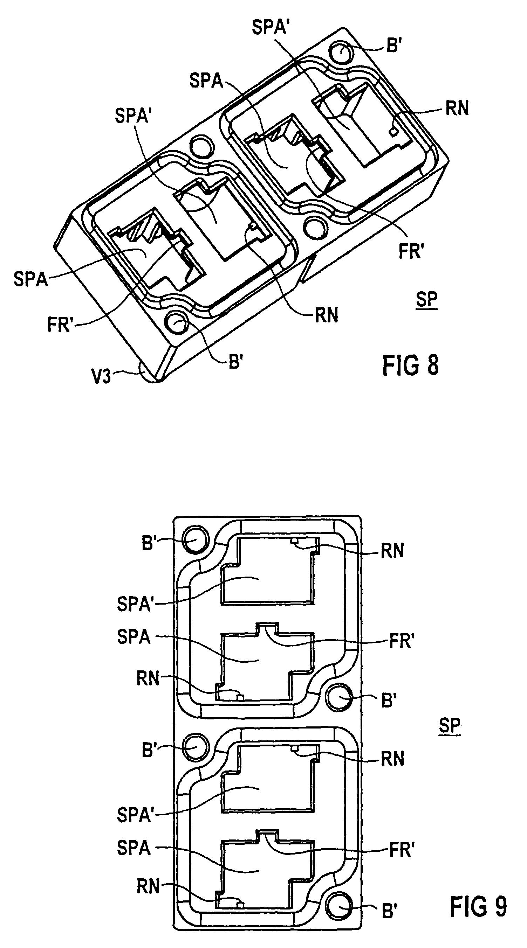

- FIG 9: eine Steckerplatte.

Das in FIG 1 dargestellte elektrische Gerät EG weist eine Kopfbaugruppe KBG auf, mit der eine Steckerplatte SP verbindbar ist, wobei mindestens ein Steckergehäuse SG entweder mit der Steckerplatte SP oder direkt mit der Kopfbaugruppe KBG verbindbar ist. An die Kopfbaugruppe KBG schließen sich weitere Module, die jeweils in ein Moduloberteil und ein Modulunterteil aufgeteilt sind, an. Dabei sind die Modulunterteile so ausgebildet, daß sich bei formschlüssigem Anreihen der ein Treppenprofil aufweisenden Modulunterteile eine selbsttragender Aufbau ergibt, wobei auf die jeweiligen Modulunterteile ein Moduloberteil aufsetzbar ist, in dem dann die jeweiligen elektrischen und/oder elektronischen Funktionen realisiert sind.

Das in FIG 1 bereits dargestellte Steckergehäuse ist in FIG 2 perspektivisch nochmals im Detail dargestellt. Jedes Steckergehäuse SG hat zwei ausbrechbare Öffnungen O für Kabelverschraubungen KV, die je nach Bedarf mittels eines Werkzeugs zu öffnen sind. Im Ausführungsbeispiel kommen als Kabelverschraubungen KV sogenannte Würgenippel KV zum Einsatz. Die Kabelverschraubungen KV werden mit dem Steckergehäuse SG mittels auf der Innenseite des Steckergehäuses SG positionsgerecht eingelegter Muttern befestigt. Das in den Figuren nicht dargestellte Kabel wird durch die Öffnung der Kabelverschraubung KV und durch die Öffnung O des Steckergehäuses hindurch gezogen. Die elektrischen Leiter des Kabels werden im Steckerelement ST angeklemmt.

FIG 3 zeigt einen Schnitt durch das Steckergehäuse SG. In dieser Darstellung ist besonder der Rastschenkel RS mit den Ausnehmungen RSSH, RSRN ersichtlich. Der Rastschenkel RS ist auf zwei gegenüberliegenden Innenseiten des Steckergehäuses SG mit diesem einstückig verbunden. Der freie Abschnitt des Rastschenkels RS ermöglicht dessen federnde Beweglichkeit.

FIG 4 zeigt eine Darstellung des Inneren des Steckergehäuse SG. In dieser Darstellung sind die Positionierelemente PE, PE' ersichtlich, die das positionsgerechte Plazieren der Muttern zur Befestigung der Würgenippel KV erleichtern. Die Positionselemente PE sind dabei zur Unterstützung des positionsgerechten Plazierens von Muttern auf einer waagerechten Ebene und die Positionselemente PE' zur Unterstützung des positionsgerechte Plazierens von Muttern in einer senkrechten Ebene vorgesehen.

Das Steckerelement ST, das im folgenden auch kurz als Stecker ST bezeichnet wird, ist perspektivisch in FIG 5 im Detail dargestellt. Der Stecker ST ist zum Steckergehäuse SG mittels seitlich angebrachter Rippen R', R'' codiert. Diese Rippen R', R'' greifen in formschlüssig ausgebildete Ausnehmungen A', A'' der Innenseite des Steckergehäuses SG ein, die in FIG 4 ersichtlich sind. Wenn z.B. die Rippe R' schmal gegenüber der Rippe R'' ist und entsprechend die Ausnehmung A' für die Rippe R' auf der Innenseite des Steckergehäuses SG schmal gegenüber der Ausnehmung A'' für die Rippe R'' ist, so ist der Stecker ST stets nur positionsrichtig in das Steckergehäuse SG einführbar. Da sich die Ausnehmungen A', A'' für die Rippen R', R'' nicht auf der gesamten Länge der Innenflächen des Steckergehäuses SG fortsetzen, wie aus FIG 3 ersichtlich ist, wirken die Rippen R', R'' in Zusammenwirken mit den entsprechenden Ausnehmungen A', A'' als Anschlag, so daß ein zu weites Einstecken des Steckers ST in das Steckergehäuse SG beim Einstecken verhindert wird.

Beim Einführen des Steckers ST bis zum durch das Zusammenwirken durch Rippen R', R'' und entsprechenden Ausnehmungen A', A'' gebildeten Anschlag verrastet der Stecker ST mit dem Steckergehäuse über die Schnapphaken SH, die in entsprechende Ausnehmungen RSSH des Rastschenkels RS einrasten. Diese Rastschenkel RS sind aus den Darstellungen der FIG 1 und 2 ersichtlich.

Zum Anklemmen der Leiter der elektrischen Leitung, die mittels des im Steckergehäuse SG angeordneten Steckers ST an das elektrische Gerät EG herangeführt werden, weist der Stecker ST Anschußvorrichtungen AV auf, die im Ausführungsbeispiel als Schraubklemmen AV ausgebildet sind.

Die FIG 6 und 7 zeigen Stecker ST einmal in einer Seitenansicht (FIG 6) und einmal in einer Ansicht von der Unterseite (FIG 7). Insbesondere aus FIG 6 geht hervor, daß die Schnapphaken SH einstückig mit dem Stecker ST derart verbunden sind, daß eine federnde Bewegung der Schnapphaken SH ermöglicht ist. Der Stecker ST weist im Bereich des Federweges der Schnapphaken SH Anschläge SHA auf, die den Federweg der Schnapphaken SH begrenzen und damit ein Überbiegen der Schnapphaken SH verhindern.

Zum Befestigen des Steckergehäuses SG auf der Steckerplatte SP, die in FIG 8 perspektivisch dargestellt ist, dient die Ausnehmung RSRN des Rastschenkels RS des Steckergehäuses SG. In die Ausnehmung RSRN des Rastschenkels RS greift die Rastnase RN der Steckerplatte SP ein. Die Rastnase RN ist als ungleichmäßiges Dreieck ausgebildet, dessen Basis mit der Seitenfläche der Steckerplatte SP, an der sie plaziert ist, zusammenfällt. Der Basiswinkel des in Richtung des aufzurastenden Steckergehäuses SG gewandten Schenkels dieses Dreiecks ist dabei kleiner als der entsprechende Winkel des verbleibenden Schenkels. Durch eine derartige Ausgestaltung der Rastnase RN wird bewirkt, daß das Aufrasten des Steckergehäuses SG auf die Steckerplatte SP leichter ist, als das Entfernen des auf die Steckerplatte SP aufgerasteten Steckergehäuses SG.

Durch die Kontur der Ausnehmungen SPA, SPA' der Steckerplatte SP, in die die Rastschenkel RS des Steckergehäuses SG eingreifen, ist die korrekte Positionierung des Steckergehäuse SG auf der Steckerplatte SP sichergestellt. Diese Ausnehmungen SPA, SPA' sind besonders in FIG 9, die die Steckerplatte SP von oben gesehen darstellt, ersichtlich. Nur bei korrekter Orientierung ist das Steckergehäuse SG auf der Steckerplatte SP aufrastbar und nur dann kommen die Bohrungen B des Steckergehäuses SG mit entsprechenden Bohrungen B' der Steckerplatte SP zur Deckung. In die bei orientierungsrichtigem Aufrasten zur Deckung gebrachten Bohrungen B, B' sind Befestigungsmittel, z.B. Gewindeschrauben, zum lösbaren Befestigen von Steckergehäuse SG und Steckerplatte SP an der Kopfbaugruppe KBG einführbar.

Sind für das Verrasten des Steckergehäuses SG mit der Steckerplatte SP noch zwei zulässige Orientierungen denkbar, so ist das Steckergehäuse SG mitsamt dem im Steckergehäuse SG eingerasteten Stecker ST nur noch in einer Orientierung mit der Steckerplatte SP verrastbar. Dazu weist das Steckerelement ST eine Führungsrippe FR auf, die in Zusammenwirken mit einer entsprechenden Ausnehmung FR' der Ausnehmung SPA der Steckerplatte SP nur noch eine seitenrichtige Positionierung des Steckergehäuses SG mitsamt dem Steckerteil ST auf der Steckerplatte SP zuläßt.

Die Steckerplatte SP weist auf einer ihrer Außenseiten eine Formschlußaufnahme FA auf, die mit einem entsprechenden, in den Figuren nicht ersichtlichen Formschlußelement der Kopfbaugruppe KBG zusammenwirkt, so daß auch die Steckerplatte SP nur in korrekter Orientierung mit der Kopfbaugruppe KBG zusammengefügt werden kann.

Darüber hinaus weist die Steckerplatte SP in Fortsetzung der Bohrungen B' zylinderförmiger Vorjustierungselemente VJ auf, die in korrespondierend gestaltete Ausnehmungen an der Kopfbaugruppe KBG eingreifen und somit die korrekte Positionierung der Steckerplatte in Bezug auf die Kopfbaugruppe erleichtern. Diese Vorjustierungselemente sind gemäß dem Ausführungsbeispiel an gegenüberleigenden Ecken der Steckerplatte SP vorgesehen

In den Bohrungen B des Steckergehäuses SG können gemäß einer vorteilhaften Ausgestaltung in den Abbildungen nicht dargestellte unverlierbare Schrauben vorgesehen sein. Diese Schrauben greifen durch entsprechende Bohrungen B' der Steckerplatte SP und ermöglichen schließlich ein lösbares Verbinden des Steckergehäuses SG und der Steckerplatte SP mit der Kopfbaugruppe KBG durch Verschrauben mit einem in der Kopfbaugruppe KBG vorgesehenen Gewinde.

Für das im Ausführungsbeispiel genannte elektrische Gerät EG sind drei Steckergehäuse SG gemäß der Erfindung vorgesehen. Ein erstes Steckergehäuse SG wird direkt auf die Kopfbaugruppe KBG aufgerastet. Dazu weist die Kopfbaugrupppe KBG, in dem Bereich, in dem der Stecker SG aufrastbar ist, Ausnehmungen KBGA, KBGA' sowie Rast- und Führungselemente RN, FR' auf, wie sie zuvor bei der Steckerplatte SP beschrieben wurden. Mittels dieses ersten Steckergehäuses SG und des darin angeordneten Steckers ST wird an das elektrische Gerät EG z.B. die Versorgungsspannung herangeführt.

Darüber hinaus weist das elektrische Gerät EG gemäß dem Ausführungsbeispiel zwei Steckergehäuse SG auf, die gemäß der vorangehenden Beschreibung mit einer Steckerplatte SP verrastbar sind, wobei die Kombination aus Steckergehäusen SG und Steckerplatte SP insgesamt mit der Kopfbaugrupppe KBG verbindbar ist.

Beim Ausführungsbeispiel wird diese Kombination aus zwei Steckergehäusen SG und einer Steckerplatte SP zum Heranführen von Busleitungen an das elektrische Gerät verwendet. Über ein Steckergehäuse SG und den darin angeordneten Stecker ST werden die Bussignale mittels elektrischer Leiter an das Gerät EG herangeführt; mittels des zweiten Steckergehäuses und des darin angeordneten Steckers ST werden die Bussignale ausgehend von diesem elektrischen Gerät EG an eventuell weitere elektrische Geräte EG herangeführt. Um ein derartiges Hindurchschleifen von Busleitungen durch ein Gerät zu ermöglichen, ist es notwendig, zumindest einige der Leiter, die an die Anschlußvorrichtungen AV des Steckers ST angeschlossen sind, miteinander zu verbinden. Dazu ist in der Steckerplatte SP z.B. eine in den Figuren nicht ersichtliche Leiterplatte vorgesehen, die die jeweiligen Kontakte der Anschlußvorrichtungen AV des ersten Steckers ST mit den korrespondierenden Anschlußvorrichtungen AV des zweiten Steckers ST elektrisch leitend verbindet.

Darüber hinaus ist diese Leiterplatte selbstverständlich so ausgebildet, daß die an die Anschlußvorrichtungen AV des Steckers ST herangeführten Potentiale und Signale auch an entsprechende, in der Kopfbaugruppe KBG angeordnete Kontaktmittel heranführbar sind. Mit einer derartigen Kombination wird bewirkt, daß die Steckerplatte SP mitsamt der darin angeordneten Leiterplatte und der auf der Steckerplatte SP aufgerasteten Steckergehäuse SG mitsamt der darin angeordneten Stecker ST von der Kopfbaugruppe KBG lösbar ist, so daß der Bus, der mittels dieser Kombination an das elektrische Gerät EG heranführbar ist, beim Wechseln des elektrischen Gerätes EG nicht unterbrochen wird.

In einer vorteilhaften Ausgestaltung sind die Komponenten der Anschlußvorrichtung, also Steckergehäuse SG, Stecker ST und Steckerplatte SP aus einem Kunststoff gefertigt. An den Kontaktstellen der einzelnen Elemente ist gemäß dem Ausführungsbeispiel eine Dichtung vorgesehen, so daß Steckergehäuse SG, Steckerplatte SP und Kopfbaugruppe KBG bzw. deren Kombination die Schutzart IP 65 erfüllen.

## Patentansprüche

1. Aus einem Steckergehäuse SG und mindestens einem Steckerelement ST gebildete Anschlußvorrichtung,
- wobei Steckerelement ST und Steckergehäuse SG lösbar verrastbar sind,
- wobei am Steckerelement ST bzw. am Steckergehäuse SG ein Rastelement SH vorgesehen ist und wobei am Steckergehäuse SG bzw. am Steckerelement ST eine Ausnehmung RSSH, in die das Rastelement SH eingreift, vorgesehen ist,
- wobei im Steckergehäuse SG eine Ausnehmung A', A'' vorgesehen ist, in der beim Verrasten von Steckergehäuse SG und Steckerelement ST am Steckerelement ST vorgesehe ne Führungskonturen R', R'' geführt werden.

2. Anschlußvorrichtung nach Anspruch 1, **dadurch gekennzeichnet,** daß das Rastelement SH am Steckerelement ST vorgesehen ist und daß die Ausnehmung RSSH, in die das Rastelement SH eingreift, am Steckergehäuse SG vorgesehen ist

3. Anschlußvorrichtung nach Anspruch 1 oder 2, **dadurch gekennzeichnet,** daß das Rastelement SH ein mit dem Steckerelement ST einstückig verbundenes Federelement SH ist.

4. Anschlußvorrichtung nach Anspruch 1, **dadurch gekennzeichnet,** daß in der Ausnehmung A' nur die Führungskontur R' und daß in der Ausnehmung A'' nur die Führungskontur R'' führbar ist.

5. Anschlußvorrichtung nach einem der obigen Ansprüche, **dadurch gekennzeichnet,** daß das Steckergehäuse SG mit einem Gegenstück SP, KBG lösbar verrastbar ist, daß das Gegenstück SP, KBG Ausnehmungen SPA, SPA', KGBA, KBGA' aufweist, daß das Gegenstück SP, KBG im Bereich der Ausnehmungen SPA, SPA', KGBA, KBGA' mindestens ein Rastelement RN aufweist, das in eine entsprechende Ausnehmung RSRN des Steckergehäuses SG eingreift.

6. Anschlußvorrichtung nach Anspruch 5, **dadurch gekennzeichnet,** daß Ausnehmung RSRN, in die das Rastelement RN eingreift, in einem mit dem Steckergehäuse einstückig verbundenen Federelement RS vorgesehen ist.

7. Anschlußvorrichtung nach einem der obigen Ansprüche, **dadurch gekennzeichnet,** daß am Steckerelement ST eine Führungskontur FR vorgesehen ist, die in eine in der Ausnehmung SPA, KBGA des Gegen-stücks SP, KBG vorgesehene Ausnehmung FR' einführbar ist.
